(19) **Europäisches Patentamt / European Patent Office / Office européen des brevets**

(11) **EP 4 527 634 A1**

(12) **EUROPEAN PATENT APPLICATION**
published in accordance with Art. 153(4) EPC

(43) Date of publication:
26.03.2025 Bulletin 2025/13

(21) Application number: 23807521.2

(22) Date of filing: 10.05.2023

(51) International Patent Classification (IPC):
**B41N 1/12** (2006.01)     **B41C 1/05** (2006.01)
**B41M 1/04** (2006.01)     **G03F 7/00** (2006.01)
**G03F 7/095** (2006.01)

(52) Cooperative Patent Classification (CPC):
**B41C 1/05; B41M 1/04; B41N 1/12; G03F 7/00; G03F 7/095**

(86) International application number:
**PCT/JP2023/017605**

(87) International publication number:
**WO 2023/223917 (23.11.2023 Gazette 2023/47)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 18.05.2022 JP 2022081622

(71) Applicant: **Asahi Kasei Kabushiki Kaisha**
**Tokyo 1000006 (JP)**

(72) Inventors:
• **SUEZAKI, Masahiro**
  **Tokyo 100-0006 (JP)**
• **NAKANO, Katsuya**
  **Tokyo 100-0006 (JP)**

(74) Representative: **Strehl & Partner mbB**
**Maximilianstrasse 54**
**80538 München (DE)**

(54) **FLEXOGRAPHIC PRINTING ORIGINAL PLATE, METHOD FOR MANUFACTURING FLEXOGRAPHIC PRINTING ORIGINAL PLATE, FLEXOGRAPHIC PRINTING PLATE, AND FLEXOGRAPHIC PRINTING METHOD**

(57)     An original flexographic printing plate containing at least: a support (a); and a photosensitive resin composition layer (b) laminated thereon,
wherein the photosensitive resin composition layer (b) contains a naphthenic hydrocarbon compound having a naphthene ratio of 60% or more and 80% or less and satisfies the following <condition 1>:
<condition 1>
a cured product obtained by molding a photosensitive resin composition constituting the photosensitive resin composition layer (b) to a thickness of 1.5 mm and irradiating from a top side and a bottom side each with 3,000 mJ of ultraviolet ray has a Shore A hardness of 60 or more and 75 or less; and
a storage modulus G' (MPa) and a loss modulus G" (MPa) of the cured product in a dynamic viscoelastic measurement at -30°C and 2.5 Hz satisfy Formulas (1) and (2) below:

$$1.04 \leq G' + G'' \leq 1.79 \quad (1)$$

$$0.15 \leq G'' \leq 0.30 \quad (2).$$

[Figure 3]

Master curve (reference 20°C)

G'+G" (MPa)

Frequency (Hz)

—●— [Example 1] sample

## Description

Technical Field

The present invention relates to an original flexographic printing plate, a method for producing a flexographic printing plate, a flexographic printing plate, and a flexographic printing method.

Background Art

Flexographic printing is an example of letterpress printing. It is a method of printing by supplying solvent-based ink containing aqueous ink, an ester solvent, and the like with an ink supply roll or the like to the surface of convex portions of a resin plate having convexo-concave portions, and then contacting the resin plate with a body to be printed, and transferring the ink on the surface of the convex portions to the body to be printed.

Recently, in the carton paper printing market of flexographic printing, there has been a demand for flexographic printing plates that can be printed at high speed. During high-speed printing, the flexographic printing plate is more likely to wear out than during low-speed printing, thus the flexographic printing plate having high hardness is generally used. However, when the hardness of the flexographic printing plate is high, the surface of the flexographic printing plate cannot completely follow the fine convexo-concave on the surface of carton paper, and there is a problem that blurs due to ink transfer defects may occur in solid image portions.

In response to the above-mentioned problems, a method for improving blurs in the solid image portions has been studied for a long time by controlling the properties of the flexographic printing plate.

For example, Patent Literature 1 proposes a technique for improving printing density unevenness, in which the printing density unevenness in flexographic printing is believed to be caused by the vibration of the flexographic printing plate during printing, and the dynamic viscoelastic properties are focused, instead of the static plate properties of Shore A hardness, and the loss tangent ($\tan\delta$) of a photocured product contained in the flexographic printing plate is controlled to a predetermined range to improve the printing density unevenness.

Patent Literature 2 proposes a technique to improve the printing density of solid image portions, in which the hardness of the cushion material laminated to the surface opposite to the surface on which a relief image is formed in the flexographic printing plate is adjusted, thereby suppressing the collapse of dot portions even in high-definition prints.

Citation List

Patent Literature

Patent Literature 1: International Publication No. WO 2007/058163
Patent Literature 2: Japanese Patent Laid-Open No. 2019-171730

Summary of Invention

Technical Problem

However, the technique disclosed in Patent Literature 1 is a technique that has been found during low-speed printing with a printing speed of 80 m/min, and the technique disclosed in Patent Literature 2 is also a control technique during low-speed printing with the similar speed. For this reason, there is a problem that, during high-speed printing with a printing speed of 450 m/min or more, a sufficient study has not yet been made from the viewpoint of improving blurs that occur in solid image portions.

Thus, an object of the present invention is to provide an original flexographic printing plate that enables obtaining a flexographic printing plate that has excellent wear resistance and can suppress the occurrence of blur in solid image portions even during high-speed printing with a printing speed, for example, of 450 m/min or more.

Solution to Problem

The present inventors have conducted diligent studies to solve the problems and have found that the above-described problems can be solved by specifying, in an original flexographic printing plate comprising a photosensitive resin composition layer comprising a naphthenic hydrocarbon compound having a predetermined naphthene ratio, a Shore A hardness and dynamic viscoelastic properties of a cured product of the photosensitive resin composition layer to a predetermined numerical range, and thereby completed the present invention.

That is, the present invention is as follows.

[1] An original flexographic printing plate comprising at least: a support (a); and a photosensitive resin composition layer (b) laminated thereon,

> wherein the photosensitive resin composition layer (b) comprises a naphthenic hydrocarbon compound having a naphthene ratio of 60% or more and 80% or less and satisfies the following <condition 1>: <condition 1>
> a cured product obtained by molding a photosensitive resin composition constituting the photosensitive resin composition layer (b) to a thickness of 1.5 mm and irradiating from a top side and a bottom side each with 3,000 mJ of ultraviolet ray has a Shore A hardness of 60 or more and 75 or less; and
> a storage modulus G' (MPa) and a loss modulus G'' (MPa) of the cured product in a dynamic viscoelastic measurement at -30°C and 2.5 Hz satisfy Formulas (1) and (2) below:

$$1.04 \leq G' + G'' \leq 1.79 \quad (1)$$

$$0.15 \leq G'' \leq 0.30 \quad (2).$$

[2] The original flexographic printing plate according to [1], wherein a ratio: $\tan\delta = G''/G'$ of the loss modulus G'' (MPa) to the storage modulus G' (MPa) of the cured product in a dynamic viscoelastic measurement at -30°C and 2.5 Hz satisfies Formula (3) below:

$$0.17 \leq \tan\delta \leq 0.20 \quad (3).$$

[3] The original flexographic printing plate according to [1] or [2], wherein the naphthene ratio of the naphthenic hydrocarbon compound is 65% or more and 73% or less.

[4] The original flexographic printing plate according to any one of [1] to [3], wherein a content of the naphthenic hydrocarbon compound in the photosensitive resin composition layer (b) is 3% by mass or more and 20% by mass or less.

[5] The original flexographic printing plate according to any one of [1] to [4], wherein

> the photosensitive resin composition layer (b) further comprises a liquid conjugated diene, and
> a content of the naphthenic hydrocarbon compound based on a total amount of the liquid conjugated diene and the naphthenic hydrocarbon compound is 91 mol% or more and 99 mol% or less.

[6] A method for producing a flexographic printing plate, using the original flexographic printing plate according to any one of [1] to [5], the method comprising:

> a first step of irradiating the original flexographic printing plate with an ultraviolet ray from the support (a) side;
> a second step of placing a negative film on the photosensitive resin composition layer (b) or laser-ablating an infrared ray ablation layer (c) provided on the photosensitive resin composition layer (b) to form a negative pattern;
> a third step of irradiating the photosensitive resin composition layer (b) with an ultraviolet ray for pattern exposure through the negative film or using, as a mask, the infrared ray ablation layer (c) on which the pattern is drawn and processed; and
> a fourth step of removing an unexposed portion of the photosensitive resin composition layer (b).

[7] A flexographic printing plate comprising a cured product of a photosensitive resin composition, wherein the cured product has a Shore A hardness of 61 or more and 77 or less; and
a storage modulus G' (MPa) and a loss modulus G'' (MPa) of the cured product in a dynamic viscoelastic measurement at -30°C and 2.5 Hz satisfy Formulas (4) and (5) below:

$$1.17 \leq G' + G'' \leq 1.80 \quad (4)$$

$$0.17 \leq G'' \leq 0.30 \quad (5).$$

[8] The flexographic printing plate according to [7], wherein a ratio: $\tan\delta = G''/G'$ of the loss modulus G'' (MPa) to the storage modulus G' (MPa) of the cured product of a photosensitive resin composition in a dynamic viscoelastic measurement at -30°C and 2.5 Hz satisfies Formula (6) below:

$$0.17 \leq \tan\delta \leq 0.20 \quad (6).$$

[9] A flexographic printing method using the flexographic printing plate according to [7] or [8], the method comprising:

an ink-attaching step of attaching ink to a convex portion of the flexographic printing plate; and
a transferring step of transferring the ink to a substrate.

Advantageous Effects of Invention

The present invention can provide an original flexographic printing plate that enables obtaining a flexographic printing plate that has excellent wear resistance and can suppress the occurrence of a blur in solid image portions even during high-speed printing with a printing speed of, for example, 450 m/min or more.

Brief Description of Drawings

[Figure 1] Figure 1 is a schematic cross-section view of an original flexographic printing plate according to the present embodiment.
[Figure 2] Figure 2 is a schematic diagram illustrating a method for producing a flexographic printing plate using the original flexographic printing plate according to the present embodiment.
[Figure 3] Figure 3 shows the relationship between the frequency of strain applied to the cured product of the photosensitive resin composition layer (b) and the sum of the storage modulus and loss modulus G'+ G" in the original flexographic printing plate of Example 1.

Description of Embodiments

Hereinafter, embodiments for carrying out the present invention (hereinafter, referred to as "present embodiment") will be described in detail.
It should be noted that the following present embodiments are examples for describing the present invention, and are not intended to limit the present invention to the following contents. The present invention can be practiced in various variations without departing from the scope thereof.

[Original Flexographic Printing Plate]

The original flexographic printing plate of the present embodiment is an original flexographic printing plate comprising at least: a support (a); and a photosensitive resin composition layer (b) laminated thereon, wherein

the photosensitive resin composition layer (b) compris a naphthenic hydrocarbon compound having a naphthene ratio of 60% or more and 80% or less and satisfies the following <condition 1>:
<condition 1>
a cured product obtained by molding a photosensitive resin composition constituting the photosensitive resin composition layer (b) to a thickness of 1.5 mm and irradiating from a top side and a bottom side each with 3,000 mJ of ultraviolet ray has a Shore A hardness of 60 or more and 75 or less; and
a storage modulus G' (MPa) and a loss modulus G" (MPa) of the cured product in a dynamic viscoelastic measurement at -30°C and 2.5 Hz satisfy Formulas (1) and (2) below:

$$1.04 \leq G' + G'' \leq 1.79 \quad (1)$$

$$0.15 \leq G'' \leq 0.30 \quad (2).$$

The configuration described above enables preparing a flexographic printing plate that has excellent printing durability and can reduce blurs that occur in solid image portions and suppress the occurrence of a blur even during high-speed printing with a printing speed of, for example, 450 m/min or more.

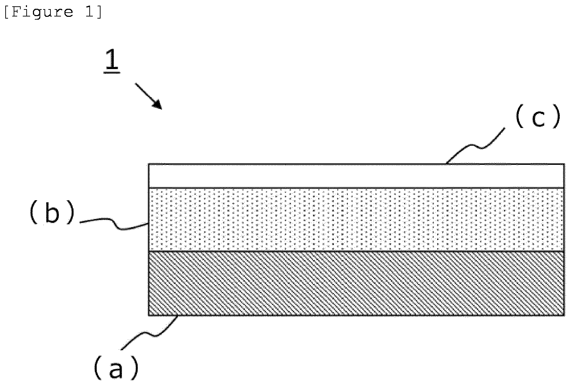

Figure 1 is a schematic cross-section view of the original flexographic printing plate 1 of the present embodiment.

The original flexographic printing plate of the present embodiment comprises a support (a) and a photosensitive resin composition layer (b) on which a convexo-concave pattern of a flexographic printing plate is formed.

In addition, the original flexographic printing plate 1 of the present embodiment may have a thin protective layer with solvent solubility and flexibility, which has the function of improving the contactability with a predetermined negative film (see, for example, Japanese Patent Publication No. 5-13305), as necessary.

In the original flexographic printing plate 1 of the present embodiment shown in Figure 1, an infrared ray ablation layer (c) that functions as a mask when the convexo-concave pattern is formed is laminated on a photosensitive resin composition layer (b).

In the original flexographic printing plate of the present embodiment, other layers may be provided between each layer as needed.

Hereinafter, the original flexographic printing plate of the present embodiment will be described.

(Support (a))

Examples of the support (a) for use in the original flexographic printing plate of the present embodiment include, but are not particularly limited to, a polyester film, a polyamide film, a polyacrylonitrile film, and a polyvinyl chloride film.

The support (a) is preferably a polyester film.

Examples of the polyester used for the support (a) include, but are not limited to, polyethylene terephthalate, polybutylene terephthalate, and polyethylene naphthalate.

The thickness of the support (a) is not particularly limited, but is preferably 50 $\mu$m or more and 300 $\mu$m or less.

An adhesive layer may be provided on the support (a) in order to enhance the adhesive force between the support (a) and the photosensitive resin composition layer (b) which will be described later. Examples of the adhesive layer include, but are not limited to, the adhesive layer described in International Publication No. WO 2004/104701.

(Photosensitive Resin Composition Layer (b))

As a result of intensive study by the present inventors, it has been found that it is important to focus on the storage modulus (G') and loss modulus (G'') in a low-temperature and low-frequency region in the photosensitive resin composition layer (b) constituting the flexographic printing plate, and in particular, to control the sum of G' and G'', and G'', from the viewpoint of demonstrating excellent wear resistance, reducing blurs in solid image portions, and suppressing the occurrence of a blur, even during high-speed printing with a printing speed of, for example, 450 m/min or more.

Generally, the complex modulus G* that is correlated with the hardness of the flexographic printing plate at rest is expressed as $|G^*| = \{(G')^2 + (G'')^2\}^{1/2}$. When a value of the one having a smaller value among G' and G'' increases or decreases, the change in the absolute value of the complex modulus is small, and no correlation with printing has been observed. We have then focused on G'+ G'', which equally reflects the change of values of both G' and G'', and have found that the correlation with printing is good. This can be said that it shows more precise control of G' and G'' is required during high-speed printing.

That is, because G'' is greatly related to blurs that occur during high-speed printing, it is effective to apply the parameter G' + G'', which can reflect the change of the value of G'' equally to the change of the value of G', to improve the printing properties during high-speed printing.

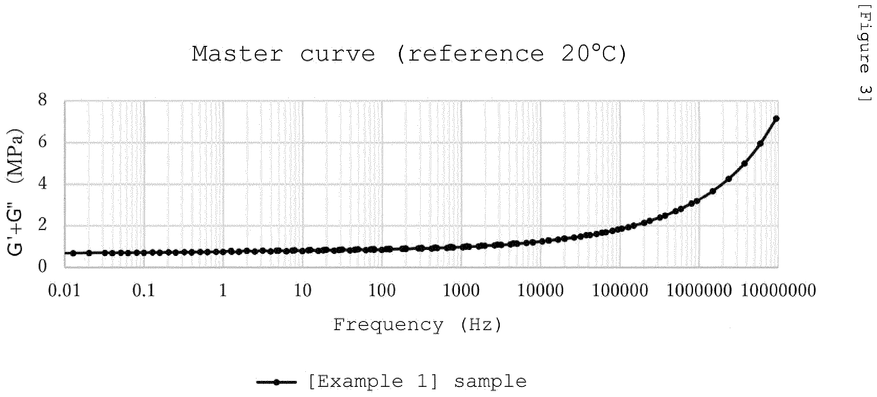

Figure 3 shows the result of creating a master curve with a reference temperature of 20°C for the sample of Example 1 described below.

In Figure 3, the horizontal axis shows the frequency of strain applied to the cured product of the photosensitive resin composition layer (b), and the vertical axis shows the sum of the observed storage modulus and loss modulus G' + G''.

As shown in Figure 3, the higher the frequency, the higher the G' + G''.

The convex portion of the flexographic printing plate is stressed when it comes into contact with a body to be printed. During high-speed printing, the period of applied force is shortened, so that the viscoelasticity of the photosensitive resin composition layer (b) also changes and corresponds to the high-frequency region. For example, when focusing on high-speed printing at a printing speed of 600 m/min in anticipation of further improvement in flexographic printing speed in the future, the frequency of the force applied to the flexographic printing plate at 20°C can be estimated to be 5,000 to 6,000 Hz in a typical printer. This is a region corresponding to -30°C and 2.5 Hz, based on the time-temperature conversion rule, and it can be seen that the viscoelasticity of the photosensitive resin composition layer (b) corresponds to the low-temperature/low-frequency region. The region corresponding to -30°C and 2.5 Hz is a region close to the glass transition temperature (Tg) region of the butadiene structure typically contained in original flexographic printing plates and flexographic printing plates to provide flexibility. With printing at higher speed, the period of force applied to the flexographic printing plate becomes higher frequency, so that the viscoelasticity of the photosensitive resin composition layer (b) corresponds to a lower-temperature measurement region based on the time-temperature conversion rule, resulting in corresponding to a low-temperature region close to Tg of butadiene. As a result, the flexibility of the flexographic printing plate is impaired, and the elastic modulus is raised, so that an end blur is more likely to occur as the printing is performed at higher speed.

To achieve excellent wear resistance, reduce end blurs during printing, and suppress the occurrence of an end blur during high-speed printing using a flexographic printing plate as described above, it is necessary that, in a dynamic viscoelastic measurement at -30°C and 2.5 Hz of a cured product obtained by molding a photosensitive resin composition constituting the photosensitive resin composition layer (b) of the original flexographic printing plate to a thickness of 1.5 mm and irradiating from a top side and a bottom side each with 3,000 mJ of ultraviolet ray, the sum $G' + G''$ of $G'$ and $G''$ described above is 1.04 or more and 1.79 or less.

In the above numerical range, the level of end blurs is significantly improved.

When $G' + G''$ is 1.04 or more, excellent printing durability is obtained in the flexographic printing plate during high-speed printing.

When $G' + G''$ is 1.79 or less, a sufficient suppression effect on the end blurs can be obtained.

From the viewpoint of compatibility of improvement of end blurs and printing durability, $G' + G''$ is preferably 1.40 or more and 1.75 or less, and more preferably 1.50 or more and 1.70 or less.

In the original flexographic printing plate of the present embodiment, the control of loss modulus $G''$ is also necessary to achieve excellent wear resistance, reduce blurs, and suppress the occurrence of a blur during high-speed printing.

The value of $G''$ is correlated with the rate at which an end blur begins to occur when the printing speed is increased.

The lower the $G''$, the less likely the occurrence of an end blur even during high-speed printing. This is believed to be because $G''$ is loss modulus and correlated with plastic deformation, and when the value of $G''$ increases, it takes time for the shape of the flexographic printing plate to recover when a deformation accompanying printing occurs and causes the occurrence of an end blur.

In the present embodiment, $G''$ is set to 0.15 or more and 0.30 or less. In the above range, the improvement effect of end blur can be achieved even during high-speed printing of 450 m/min or more.

When $G''$ is 0.30 or less, an end blur can be effectively suppressed even during high-speed printing of 450 m/min or more.

When $G''$ is less than 0.15, the production becomes difficult, thus $G''$ is 0.15 or more from a practical viewpoint.

To demonstrate the effects even during high-speed printing, $G''$ is preferably 0.15 or more and 0.29 or less, and more preferably 0.15 or more and 0.24 or less.

To reduce $G'$ and $G''$ in the dynamic viscoelasticity measurement at -30°C and 2.5 Hz, it is effective to add a plasticizer having the specific structure described below to the photosensitive resin composition. The plasticizer having a specific structure can reduce Tg of the butadiene structure in the photosensitive resin composition.

$G''$ can also be reduced by adjusting the composition of the thermoplastic elastomer (b-1) described later.

That is, the numerical range of formula (1) and formula (2) described above can be controlled by the plasticizer described later and adjusting the composition of the thermoplastic elastomer (b-1).

$G'$ and $G''$ can be measured by the method described in Examples described below.

In the original flexographic printing plate of the present embodiment, the ratio: $\tan\delta = G''/G'$ of the loss modulus $G''$ (MPa) to the storage modulus $G'$ (MPa) in the dynamic viscoelastic measurement at -30°C and 2.5 Hz as described above is preferably 0.17 or more and 0.20 or less, more preferably 0.17 or more and 0.19 or less, and even more preferably 0.17 or more and 0.18 or less.

With the above numerical range, the effect of improving end blurs and suppressing the occurrence of an end blur can be obtained even when printing at a higher speed.

$\tan\delta$ can be controlled to the numerical ranges described above by the plasticizer described later and adjusting the composition of the thermoplastic elastomer.

In the original flexographic printing plate of the present embodiment, the cured product of the photosensitive resin composition layer (b) of a thickness of 1.5 mm described above has a Shore A hardness of 60 or more and 75 or less.

When a Shore A hardness of the cured product is 60 or more, sufficient printing durability can be provided in the flexographic printing plate. When a Shore A hardness is 75 or less, the flexographic printing plate has sufficient bendability, and for example, the workability of wrapping the flexographic printing plate around a plate cylinder becomes good. From the viewpoint of compatibility of printing durability and bendability of the flexographic printing plate, the Shore A hardness is 60 or more and 75 or less, preferably 62 or more and 73 or less, and more preferably 64 or more and 70 or less.

The Shore A hardness of the cured product can be measured by the method described in Examples described below and can be controlled to the above numerical range by adjusting the structure and content of the later-described thermoplastic elastomer (b-1) contained in the photosensitive resin composition.

The original flexographic printing plate of the present embodiment has the photosensitive resin composition layer (b) on the support (a).

The photosensitive resin composition layer (b) may be laminated directly on the support (a) or may be indirectly laminated via a predetermined adhesive layer or the like.

Preferred examples of the material of the photosensitive resin composition layer (b) can include a photosensitive resin composition comprising a thermoplastic elastomer (b-1), an ethylenically unsaturated compound (b-2), a photopolymerization initiator (b-3), and a naphthenic hydrocarbon compound (b-4). These can be used selectively as appropriate. The photosensitive resin composition layer (b) may further contain a liquid diene. The photosensitive resin composition layer (b) may further contain an auxiliary additive component, if necessary. Hereinafter, each component is described in detail.

<Thermoplastic Elastomer (b-1)>

Examples of the thermoplastic elastomer (b-1) include, but are not limited to, a copolymer having a constituent unit derived from a monovinyl-substituted aromatic hydrocarbon and a constituent unit derived from a conjugated diene. The thermoplastic elastomer (b-1) may further have a constituent unit derived from other monomers. The use of such a thermoplastic elastomer tends to further improve the printing durability of a flexographic printing plate produced using the original flexographic printing plate according to the present embodiment.

The thermoplastic elastomer (b-1) may be a random copolymer or a block copolymer, but is preferably a block copolymer having a polymer block formed from a monovinyl-substituted aromatic hydrocarbon and a polymer block formed from a conjugated diene.

The use of such a thermoplastic elastomer tends to further improve a printing durability of the flexographic printing plate produced using the original flexographic printing plate according to the present embodiment.

Examples of the monovinyl-substituted aromatic hydrocarbon that constitutes the thermoplastic elastomer (b-1) include, but are not limited to, styrene, t-butylstyrene, 1,1-diphenylethylene, N,N-dimethyl-p-aminoethylstyrene, N,N-diethyl-p-aminoethylstyrene, vinylpyridine, p-methylstyrene, p-methoxystyrene, tertiary-butylstyrene, $\alpha$-methylstyrene, and 1,1-diphenylethylene. These may be used singly or in combinations of two or more thereof.

Among these, the monovinyl-substituted aromatic hydrocarbon is preferably styrene, from the viewpoint of enabling the photosensitive resin composition layer (b) to be molded smoothly at a relatively low temperature.

Examples of the conjugated diene that constitutes the thermoplastic elastomer (b-1) include, but are not limited to, 1,3-butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene. These may be used singly or in combinations of two or more thereof.

Among these, the conjugated diene is preferably 1,3-butadiene from the viewpoint of printing durability of the flexographic printing plate produced using the original flexographic printing plate of the present embodiment.

The thermoplastic elastomer (b-1) preferably has a number average molecular weight (Mn) of 20,000 or more and 300,000 or less, and more preferably 50,000 or more and 200,000 or less from the viewpoint of viscosity at normal temperature. The number average molecular weight can be measured by gel permeation chromatography (GPC) and is expressed by a molecular weight in terms of polystyrene.

When the thermoplastic elastomer (b-1) is a block copolymer having a polymer block formed from a monovinyl-substituted aromatic hydrocarbon and a polymer block formed from a conjugated diene, examples of the thermoplastic elastomer (b-1) include linear block copolymers represented by the following formula group (I) and/or linear block copolymers or radial block copolymers represented by the following formula group (II).

Formula group (I):        $(A-B)_n$, $A-(B-A)_n$, $A-(B-A)_n-B$, $B-(A-B)_n$

Formula group (II):        $[(A-B)_k]_m-X$, $[(A-B)_k-A]_m-X$, $[(B-A)_k]_m-X$, $[(B-A)_k-B]_m-X$

In the formula group (I) and the formula group (II), A represents a polymeric block consisting of a monovinyl-substituted aromatic hydrocarbon. B represents a polymeric block consisting of a conjugated diene. X represents a residual group of a coupling agent selected from the group consisting of silicon tetrachloride, tin tetrachloride, epoxidized soybean oil, a poly(halogenated hydrocarbon) compound, a carboxylic acid ester compound, a polyvinyl compound, a bisphenol-type epoxy compound, an alkoxysilane compound, a halogenated silane compound, an ester-based compound, and the like, or a residual group of a polymerization initiator such as a multifunctional organolithium compound.

In the formula group (I) and the formula group (II), n, k, and m each represent an integer of at least one, for example, 1 to 5.

The content of the conjugated diene and of the monovinyl-substituted aromatic hydrocarbon in the thermoplastic elastomer (b-1) can be measured using a nuclear magnetic resonance apparatus ($^1$H-NMR). Specifically, the contents can be measured by using JNM-LA400 (manufactured by JEOL Ltd., trade name) as a $^1$H-NMR measurement device, using deuterated chloroform as a solvent, setting the sample concentration to 50 mg/mL, setting a measurement frequency at 400 MHz, using tetramethylsilane (TMS) as a standard of chemical shifts, and setting a pulse delay to 2.904 seconds, the number of times of scanning to 64, a pulse width to 45°, and a measurement temperature to 25°C.

When the ratio of monovinyl-substituted aromatic hydrocarbons is reduced in the thermoplastic elastomer (b-1), the hardness of the flexographic printing plate produced using the original flexographic printing plate of the present embodiment is lowered, and thus the bendability of the flexographic printing plate is improved. When the ratio of monovinyl-substituted aromatic hydrocarbon increases, the hardness of the flexographic printing plate is raised, and thus printing durability of the flexographic printing plate is improved. From the viewpoint of compatibility of bendability and printing durability of the flexographic printing plate, the copolymerization ratio (mass ratio) between the monovinyl-substituted aromatic hydrocarbon and the conjugated diene is preferably in the range of monovinyl-substituted aromatic hydrocarbon/conjugated diene = 10/90 to 60/40, more preferably in the range of 15/85 to 50/50, and further preferably in the range of 15/85 to 40/60.

In the thermoplastic elastomer (b-1), when the ratio of double bonds in the side chain of the double bonds contained in the polymer block consisting of a conjugated diene is reduced, the loss modulus G" at -30°C and 2.5 Hz in the cured product obtained by molding a photosensitive resin composition constituting the photosensitive resin composition layer (b) of the original flexographic printing plate of the present embodiment to a thickness of 1.5 mm and curing with an ultraviolet ray is reduced. Thus, from the viewpoint of controlling the dynamic viscoelasticity, the molar ratio of the amount of double bonds in the side chain of all the double bonds contained in the polymer block consisting of the conjugated diene in the structure of the thermoplastic elastomer (b-1) is preferably 3 mol% or more and 30 mol% or less, and more preferably 3 mol% or more and 25 mol% or less.

The ratio of the amount of the double bond contained in the main chain to the amount of double bond contained in the side chain in the polymer block consisting of the conjugated diene in the thermoplastic elastomer (b-1) can be calculated using the nuclear magnetic resonance apparatus ($^1$H-NMR) described above.

By increasing the content of thermoplastic elastomer (b-1) in the photosensitive resin composition layer (b), the printing durability of the flexographic printing plate produced using the original flexographic printing plate of the present embodiment tends to be improved. When the content of the thermoplastic elastomer (b-1) in the photosensitive resin composition (b) decreases, the hardness of the flexographic printing plate is lowered, and the bendability of the flexographic printing plate is improved. From the viewpoint of compatibility of printing durability and bendability of the flexographic printing plate, when the total amount of the photosensitive resin composition layer (b) is 100.0% by mass, the content of the thermoplastic elastomer (b-1) in the photosensitive resin composition layer (b) is preferably 40.0% by mass or more and 80.0% by mass or less, and more preferably 50.0% by mass or more and 75.0% by mass or less.

<Ethylenically Unsaturated Compound (b-2)>

The photosensitive resin composition layer (b) preferably contains an ethylenically unsaturated compound (b-2), as described above. The ethylenically unsaturated compound (b-2) is a compound having a radically polymerizable unsaturated double bond.

Examples of the ethylenically unsaturated compound (b-2) include, but are not limited to, olefins such as ethylene, propylene, o-vinyltoluene, m-vinyltoluene, p-vinyltoluene, styrene, o-divinylbenzene, m-vinylbenzene, p-vinylbenzene; acetylenes; (meth)acrylic acid and/or derivatives thereof; haloolefins; unsaturated nitriles such as acrylonitrile; unsaturated amides such as acrylamide or methacrylamide, and derivatives thereof; unsaturated dicarboxylic acids and derivatives thereof such as maleic anhydride, maleic acid, and fumaric acid; vinyl acetates; N-vinylpyrrolidone; N-vinylcarbazole; and N-substituted maleimide compounds.

Among these, from the viewpoint of ultraviolet ray curability and printing durability of the photosensitive resin composition layer (b) after curing, the ethylenically unsaturated compound (b-2) is preferably (meth)acrylic acid and/or derivatives thereof.

Examples of each of the derivatives include, but are not limited to, an alicyclic compound having a cycloalkyl group, a bicycloalkyl group, a cycloalkenyl group, a bicycloalkenyl group, or the like; an aromatic compound having a benzyl group, a phenyl group, a phenoxy group, a naphthalene skeleton, an anthracene skeleton, a biphenyl skeleton, a phenanthrene skeleton, a fluorene skeleton, or the like; a compound having an alkyl group, a halogenated alkyl group, an alkoxyalkyl group, a hydroxyalkyl group, an aminoalkyl group, a glycidyl group, or the like; an ester compound with a polyhydric alcohol such as an alkylene glycol, a polyoxyalkylene glycol, a polyalkylene glycol, or trimethylolpropane; and a compound having a polysiloxane structure, such as polydimethylsiloxane and polydiethylsiloxane.

In addition, the ethylenically unsaturated compound (b-2) may be a heteroaromatic compound containing an element such as nitrogen or sulfur.

Examples of the (meth)acrylic acid and/or derivatives thereof include, but are not limited to, a diacrylate and a dimethacrylate of an alkanediol such as hexanediol or nonanediol; a diacrylate and a dimethacrylate of ethylene glycol, diethylene glycol, propylene glycol, dipropylene glycol, polyethylene glycol, or butylene glycol; trimethylolpropane tri(meth)acrylate; dimethylol tricyclodecane di(meth)acrylate; isobornyl (meth)acylate; phenoxy polyethylene glycol (meth)acrylate; and pentaerythrit tetra (meth) acrylate.

These may be used singly or in combinations of two or more thereof.

From the viewpoint of the mechanical strength of a flexographic printing plate produced using the original flexographic printing plate according to the present embodiment, at least one (meth)acrylate is preferably used, and at least one bifunctional (meth)acrylate is more preferably used as the ethylenically unsaturated compound (b-2).

The number average molecular weight (Mn) of the ethylenically unsaturated compound (b-2) is preferably 100 or more from the viewpoint of improving nonvolatility of the ethylenically unsaturated compound (b-2) during production and/or storage of the original flexographic printing plate according to the present embodiment, preferably less than 1000 from the viewpoint of compatibility with the other components, and more preferably 200 or more and 800 or less.

Regarding the content of the ethylenically unsaturated compound (b-2) in the photosensitive resin composition layer (b), when the content of the ethylenically unsaturated compound (b-2) decreases, the hardness of the flexographic printing plate produced using the original flexographic printing plate of the present embodiment is lowered, and the bendability of the flexographic printing plate is improved. When the content of the ethylenically unsaturated compound (b-2) increases, the hardness of the flexographic printing plate is raised, thus the printing durability is improved. From the viewpoint of compatibility of bendability and printing durability of the flexographic printing plate, the content of the ethylenically unsaturated compound (b-2) is preferably 2.0% by mass or more and 25.0% by mass or less, and more preferably 5.0% by mass or more and 20.0% by mass or less when the total amount of the photosensitive resin composition layer (b) is 100.0% by mass.

Furthermore, from the viewpoint of viscoelasticity of the cured product formed by molding the photosensitive resin composition layer (b) constituting the original flexographic printing plate of the present embodiment to a thickness of 1.5 mm, it is further preferable that the content of the ethylenically unsaturated compound (b-2) in the photosensitive resin composition layer (b) is 5.0% by mass or more and 15.0% by mass or less, since the decrease of the content of the ethylenically unsaturated compound (b-2) reduces $G' + G''$ at -30°C and 2.5 Hz.

<Photopolymerization Initiator (b-3)>

The photosensitive resin composition layer (b) preferably contains a photopolymerization initiator (b-3). The photopolymerization initiator (b-3) is a compound that absorbs the energy of light to produce a radical. Examples thereof include a degradable photopolymerization initiator, a hydrogen abstraction type photopolymerization initiator, and a compound having a site functioning as a hydrogen abstraction type photopolymerization initiator and a site functioning as a degradable photopolymerization initiator in the same molecule.

Examples of the photopolymerization initiator (b-3) include, but are not limited to, benzophenones such as benzophenone, 4,4-bis(diethylamino)benzophenone, 3,3',4,4'-benzophenone tetracarboxylic anhydride, and 3,3',4,4'-tetramethoxy benzophenone; anthraquinones such as t-butyl anthraquinone and 2-ethyl anthraquinone; thioxanthones such as 2,4-diethyl thioxanthone, isopropyl thioxanthone, and 2,4-dichloro thioxanthone; Michler's ketone; acetophenones such as diethoxyacetophenone, 2,2-dimethoxy-2-phenylacetophenone, 2-hydroxy-2-methyl-1-phenylpropan-1-one, benzyl dimethyl ketal, 1-hydroxycyclohexyl-phenyl ketone, 2-methyl-2-morpholino(4-thiomethylphenyl)propan-1-one, 2-methyl-1-(4-methylthiophenyl)-2-morpholino-propan-1-one, 2-benzyl-2-dimethylamino-1-(4-morpholinophenyl)-butanone, and trichloroacetophenone; benzoin ethers such as benzoin methyl ether, benzoin ethyl ether, benzoin isopropyl ether, and benzoin isobutyl ether; acylphosphine oxides such as 2,4,6-trimethylbenzoyl diphenyl phosphine oxide, bis(2,6-dimethoxybenzoyl)-2,4,4-trimethyl pentyl phosphine oxide, and bis(2,4,6-trimethylbenzoyl)-phenyl phosphine oxide; methyl benzoylformate; 1,7-bisacridinyl heptane; 9-phenyl acridine; and azo compounds such as azobisisobutyronitrile, diazonium compounds, and tetrazene compounds.

These may be used singly or in combinations of two or more thereof.

Among these, in view of the hardness of the flexographic printing plate produced using the original flexographic printing plate according to the present embodiment, the photopolymerization initiator (b-3) is preferably a compound having a carbonyl group, and more preferably an aromatic carbonyl compound such as benzophenones or thioxanthones.

When the content of the photopolymerization initiator (b-3) in the photosensitive resin composition layer (b) decreases, the hardness of the flexographic printing plate produced using the original flexographic printing plate of the present embodiment is lowered, and the bendability of the flexographic printing plate is improved. When the content of the photopolymerization initiator (b-3) increases, the hardness of the flexographic printing plate is raised, thus the printing durability of the flexographic printing plate is improved. From the viewpoint of compatibility of bendability and printing durability of the flexographic printing plate, the content of the photopolymerization initiator (b-3) in the photosensitive resin composition layer (b) is preferably 0.1% by mass or more and 10.0% by mass or less, more preferably 0.5% by mass or more and 5.0% by mass or less, and further preferably 1.0% by mass or more and 5.0% by mass or less when the total amount of the photosensitive resin composition layer (b) is 100.0% by mass.

<Naphthenic Hydrocarbon Compound (b-4)>

In the original flexographic printing plate of the present embodiment, the photosensitive resin composition layer (b) contains a naphthenic hydrocarbon compound.

The naphthenic hydrocarbon compound is a hydrocarbon containing at least one saturated ring (naphthene ring) in a molecule and represented by the general formula of $C_nH_{2n}$. The naphthenic hydrocarbon compounds present in crude oil and petroleum products include those in which two or three naphthene rings described above are connected, the naphthene ring is fused with an aromatic ring, and those in which various paraffin side chains are attached to the naphthene ring and fused ring.

Because the naphthenic hydrocarbon compound has at least one naphthene ring in a molecule and has a stereoscopically large molecular structure, the naphthenic hydrocarbon compound preferentially plasticizes blocks consisting of butadiene polymers having a high degree of freedom in molecular motion rather than blocks consisting of styrene polymers forming a $\pi$-$\pi$ stacking structure in the thermoplastic elastomer (b-1).

From the viewpoint of cold flow resistance in the original flexographic printing plate of the present embodiment, a naphthenic hydrocarbon compound that preferentially plasticizes blocks consisting of butadiene polymers in thermoplastic elastomer (b-1) is used as the plasticizer used in the original flexographic printing plate of the present embodiment.

When a naphthenic hydrocarbon compound is used in the photosensitive resin composition (b) in the original flexographic printing plate of the present embodiment, when the proportion of naphthene rings (hereinafter referred to as naphthene ratio) in the naphthenic hydrocarbon compound is reduced, the blocks consisting of styrene polymers in the thermoplastic elastomer (b-1) are also plasticized, and cold flow resistance is worsened.

When the naphthene ratio is too large, the stereoscopic barrier becomes larger, thus the effect of plasticizing the block consisting of the butadiene polymer in the thermoplastic elastomer (b-1) is weakened, and it tends to be difficult to control the low-temperature viscoelasticity of the photosensitive resin composition (b). Thus, the naphthenic hydrocarbon compound is set to have a naphthene ratio of 60% or more and 80% or less, preferably 65% or more and 73% or less, and further preferably 67% or more and 71% or less.

The naphthene ratio is a value (percentage of naphthene carbon number to total carbon number: naphthene ratio) derived from V.G.C (viscosity specific gravity constant) and $r_i$ (refractive index) measured in accordance with ASTM D2140-08 (2017) according to the Kurtz method.

The following method is used to extract a naphthenic hydrocarbon compound from the original flexographic printing plate of the present embodiment.

[Method for Extracting Naphthenic Hydrocarbon Compound]

The naphthenic hydrocarbon compound is extracted from the original flexographic printing plate by dissolving the photosensitive resin composition on the original flexographic printing plate in tetrahydrofuran, and isolating a fraction having a peak average molecular weight (Mp) of 500 or more and 2000 or less using gel chromatography (GPC) with the following device and conditions:

Device: Alliance GPC manufactured by Waters Corporation
Column: The following four columns were connected in series to separate naphthenic hydrocarbon compounds. SHODEX KF-801 $\times$ 2, KF-802, and KF-803, all manufactured by Showa Denko K.K.
Column temperature: 40°C
Solvent: tetrahydrofuran
Detector: SHODEX RI-101 manufactured by Showa Denko K.K.
Calibration curve: standard polystyrene

In the original flexographic printing plate of the present embodiment, the content of the naphthenic hydrocarbon compound in the photosensitive resin composition layer (b) is preferably 3% by mass or more and 20% by mass or less, more preferably 5% by mass or more and 15% by mass or less, and further preferably 7% by mass or more and 13% by mass or less.

When the content is 3% by mass or more, an effect of reducing the extent of end blurs during high-speed printing is obtained.

When the content is 20% by mass or less, an effect of improving plate printing durability during high-speed printing is obtained.

In addition, the content of the naphthenic hydrocarbon compound based on the total amount of the liquid conjugated diene and the naphthenic hydrocarbon compound contained in the photosensitive resin constitute layer (b) is preferably 91 mol% or more and 99 mol% or less, more preferably 94 mol% or more and 99 mol% or less, and further preferably 96 mol% or more and 99 mol% or less to control the tan$\delta$ at -30°C and 2.5 Hz to a numerical range of 0.17 or more and 0.20 or less in the cured product formed by molding the photosensitive resin composition layer (b) constituting the original flexographic printing plate of the present embodiment to a thickness of 1.5 mm.

The photosensitive resin composition layer (b) may further contain another compound as a plasticizer.

Examples of the another compound include, but are not limited to, a paraffinic hydrocarbon compound, an olefinic hydrocarbon compound, and a naphthenic hydrocarbon compound.

The paraffinic hydrocarbon compound is a saturated chain compound of the molecular formula $C_nH_{2n+2}$ and includes unbranched normal paraffins and branched isoparaffins.

The olefinic hydrocarbon compound is a chain hydrocarbon having a double bond and is represented by the general formula of $C_nH_{2n}$ when the chain hydrocarbon has one double bond.

<Liquid Diene>

The photosensitive resin composition layer (b) preferably contains a liquid diene.

The liquid diene is a liquid compound having a carbon-carbon double bond.

In the present specification, "liquid" in the "liquid diene" means a characteristic having the property of being easily flow-deformable and capable of being solidified into a deformed shape by cooling. The liquid diene has an elastomeric property including the following property: when an external force is applied, deformation occurs instantly depending on the external force, and when the external force is removed, the original shape is recovered in a short time.

The liquid diene can be distinguished from the thermoplastic elastomer (b-1) and the ethylenically unsaturated compound (b-2) in that it is liquid at normal temperature and has elastomeric properties.

Examples of the liquid diene include, but are not limited to, liquid polybutadiene, liquid polyisoprene, a modified product of liquid polybutadiene, a modified product of liquid polyisoprene, a liquid acrylonitrile-butadiene copolymer, and a liquid styrene-butadiene copolymer.

The liquid diene is defined as a copolymer having a diene component of 50% by mass or more.

Among these, the liquid diene is preferably liquid polybutadiene from the viewpoint of mechanical properties of the original flexographic printing plate of the present embodiment and the flexographic printing plate produced using the same.

The amount of 1,2-vinyl bond in the liquid diene, preferably liquid polybutadiene, is preferably 1% or more and 80% or less, more preferably 5% or more and 70% or less, and still more preferably 5% or more and 65% or less from the viewpoint of making the hardness of the original flexographic printing plate according to the present embodiment, and the hardness of a flexographic printing plate produced using the same appropriate.

"The amount of the 1,2-vinyl bond" is a proportion of a conjugated diene monomer incorporated by a 1,2-bond in conjugated diene monomers incorporated by bonding forms of the 1,2-bond and a 1,4-bond. The amount of the 1,2-vinyl bond can be determined from the peak ratio of the $^1$H-NMR (magnetic resonance spectrum) of liquid polybutadiene.

1,2-Polybutadiene, which is the liquid polybutadiene having the 1,2-vinyl bond, is highly reactive in radical polymerization and is preferable from the viewpoint of enhancing the hardness of the photosensitive resin composition layer (b) because vinyl, which has a double bond, forms a side chain.

The liquid polybutadiene is usually a mixture of 1,2-polybutadiene having the 1,2-vinyl bond and 1,4-polybutadiene having the 1,4-vinyl bond, and it is effective that 1,4-polybutadiene is contained in the liquid diene in order to improve the softness of the original flexographic printing plate according to the present embodiment, and the softness of a flexographic printing plate produced using the same. 1,4-Polybutadiene includes cis-1,4-polybutadiene and trans-1,4-polybutadiene. Any of cis- and trans-1,4-polybutadiene has a low reactivity in radical polymerization because a vinyl group, which has a double bond, exists inside, so that a soft resin can be formed.

When a plurality of liquid polybutadienes each having a different amount of the 1,2-vinyl bond are mixed and used, the average value of the amounts is defined as the amount of the 1,2-vinyl bond.

From the viewpoint of capable of adjusting the reactivity of the photosensitive resin composition layer (b) easily, the whole amount of the 1,2-vinyl bond is preferably adjusted by mixing liquid polybutadiene having an amount of the 1,2-vinyl bond of 10% or less and liquid polybutadiene having an amount of the 1,2-vinyl bond of 80% or more. The whole amount of the 1,2-vinyl bond is preferably adjusted by mixing liquid polybutadiene having an amount of the 1,2-vinyl bond of 5% or less and liquid polybutadiene having an amount of the 1,2-vinyl bond of 80% or more, more preferably.

The number average molecular weight of the liquid diene is not particularly limited as long as it is liquid at 20°C, but is preferably 500 or more and 60000 or less, more preferably 500 or more and 50000 or less, and still more preferably 800 or more and 50000 or less from the viewpoint of the printing durability and handling properties of a flexographic printing plate produced using the original flexographic printing plate according to the present embodiment.

When the content of the liquid diene in the photosensitive resin composition layer (b) decreases, the $\tan\delta$ at -30°C and 2.5 Hz in the cured product formed by molding the photosensitive resin composition layer (b) constituting the original flexographic printing plate of the present embodiment to a thickness of 1.5 mm is reduced. Thus, the content of the liquid diene in the photosensitive resin composition layer (b) is preferably 5.0% by mass or more and 30.0% by mass or less, more preferably 5.0% by mass or more and 25.0% by mass or less, and further preferably 5.0% by mass or more and 20.0% by mass or less when the total amount of the photosensitive resin composition layer (b) is 100.0% by mass.

<Auxiliary Additive Component>

Examples of the auxiliary additive component include, but are not limited to, a thermal polymerization inhibitor other than a stabilizer, an antioxidant, an ultraviolet ray absorber, and a dye or pigment.

As the thermal polymerization inhibitor and the antioxidant, those usually used in the field of resin materials or rubber materials can be used. Specific examples thereof include a phenol-based material.

Examples of the phenol-based material include, but are not limited to, vitamin E, tetrakis-(methylene-3-(3',5'-di-t-butyl-4'-hydroxyphenyl)propionate)methane, 2,5-di-t-butylhydroquinone, 2,6-di-t-butyl-p-cresol, and 2-t-butyl-6-(3-t-butyl-2-hydroxy-5-methylbenzyl)-4-methylphenyl acrylate.

The thermal polymerization inhibitor and the antioxidant may be used singly or in combinations of two or more thereof.

Examples of the ultraviolet ray absorber include, but are not limited to, known benzophenone-based, salicylate-based, acrylonitrile-based, metal complex-based, or hindered amine-based compounds.

The dye or pigment described below may also be used as the ultraviolet ray absorber.

Examples of the ultraviolet ray absorber include, but are not particularly limited to, 2-ethoxy-2'-ethyloxalic acid bisanilide, and 2,2'-dihydroxy-4-methoxybenzophenone.

The dye or pigment is effective as coloring means for improving visibility.

Examples of the dye include, but are not limited to, a basic dye, an acid dye, and a direct dye, which are water-soluble, and a sulfur dye, an oil-soluble dye, and a disperse dye, which are non-water-soluble. Particularly, an anthraquinone-based dye, an indigoid-based dye, and an azo-based dye are preferable, and an azo-based oil-soluble dye and the like are more preferable.

Examples of the pigment include, but are not limited to, a natural pigment, a synthetic inorganic pigment, and a synthetic organic pigment. Examples of the synthetic organic pigment include an azo-based pigment, a triphenylmethane-based pigment, a quinoline-based pigment, an anthraquinone-based pigment, and a phthalocyanine-based pigment.

The total amount of the above-described auxiliary additive components to be added is preferably 0.1% by mass or more and 10.0% by mass or less, more preferably 0.1% by mass or more and 5.0% by mass or less, and still more preferably 0.1% by mass or more and 3.0% by mass or less when the whole amount of the photosensitive resin composition layer (b) is assumed to be 100.0% by mass.

(Protective Layer)

Since the photosensitive resin composition that constitutes the photosensitive resin composition layer (b) typically has tackiness, a protective layer with solvent solubility may be provided on the surface of the photosensitive resin composition layer (b) to improve contactability with the negative film superimposed thereon during plate making of the flexographic printing plate or to enable reuse of the negative film.

It is preferable that the protective layer contains a substance soluble in a solvent such as a solvent used as a washing solution, and is thin and flexible.

Examples of the protective layer include protective layers containing crystalline 1,2-polybutadiene, soluble polyamide, partially saponified polyvinyl acetate, cellulose ester, and the like, and among which soluble polyamide is preferred. These substances may be dissolved in a suitable solvent and the obtained solution may be applied to coat directly the surface of the photosensitive resin composition layer (b), or they may be once applied to coat a film such as polyester or polypropylene and the film coated with the above substances may be laminated to the photosensitive resin composition layer (b) and transferred.

(Infrared Ray Ablation Layer (c))

The original flexographic printing plate of the present embodiment may comprise an infrared ray ablation layer (c) containing an infrared ray sensitive substance, which is laminated on the photosensitive resin composition layer (b), instead of the protective layer described above.

The infrared ray ablation layer (c) is preferably composed of a binder polymer, an infrared ray-sensitive substance, and a non-infrared radiation shielding substance.

Examples of the binder polymer include a polyamide, a polyester, and a copolymer consisting of a monovinyl-substituted aromatic hydrocarbon and a conjugated diene. Among them, a copolymer consisting of a monovinyl-substituted aromatic hydrocarbon such as styrene, $\alpha$-methylstyrene, vinyltoluene, and a conjugated diene such as 1,3-butadiene or isoprene is preferred.

When the infrared ray ablation layer (c) is composed using the binder polymer, it has high affinity with the photosensitive resin composition and good adhesion.

When a polyester is used as the binder polymer, the number average molecular weight of the polyester is preferably 300 or more and 10,000 or less.

Preferred examples of the polyester include a polyester synthesized from alkanediol and adipic acid, a polyester synthesized from alkanediol and phthalic acid, a polycaprolactone, and a combination of two or more of these polyesters. The polyester may contain various functional groups such as an amino group, a nitro group, a sulfonic acid group, a halogen, and the like to the extent that the compatibility with other binder polymer, infrared ray sensitive substance, and non-infrared radiation shielding substance is not impaired.

As the infrared ray-sensitive substance, for example, a single substance or compound having strong absorption, usually in the range of 750 to 2000 nm, is preferably used.

Specific examples of the infrared ray-sensitive substance include inorganic pigments such as carbon black, graphite, copper chromite, and chromium oxide; and dyes such as polyphthalocyanine compounds, cyanine dyes, and metal thiolate dyes.

These infrared ray-sensitive substances are added to the extent that they confer a sensitivity that can be removed with the laser beam used. Generally, an addition of 10-80% by mass is effective.

For the non-infrared radiation shielding substance, a substance that reflects or absorbs radiation such as ultraviolet rays can be used. Preferred examples thereof include a radiation absorber such as ultraviolet rays, and carbon black, and graphite. The addition amount thereof is set so that the required optical density can be achieved. It is generally preferred that the non-infrared radiation shielding substance is added such that the optical density is 2 or more, preferably 3 or more.

[Method for Producing Flexographic Printing Plate]

The method for producing a flexographic printing plate according to the present embodiment, using the original flexographic printing plate of the present embodiment, includes: a first step of performing ultraviolet ray irradiation from the support (a) side; a second step of placing a negative film on the photosensitive resin composition layer (b) or laser-ablating an infrared ray ablation layer (c) provided on the photosensitive resin composition layer (b) with irradiation of infrared ray to form a negative pattern; a third step of irradiating the photosensitive resin composition layer (b) with an ultraviolet ray for pattern exposure through the negative film or using, as a mask, the infrared ray ablation layer (c) on which the pattern is drawn and processed; and a fourth step of removing an unexposed portion of the photosensitive resin composition layer (b).

If necessary, the step of performing a post-exposure treatment is then performed to obtain a flexographic printing plate (letterpress printing plate) formed from a cured photosensitive resin composition layer (b).

The surface of the flexographic printing plate may be brought into contact with a liquid containing a silicone compound and/or a fluorine compound from the viewpoint of conferring peeling properties from ink or a body to be printed.

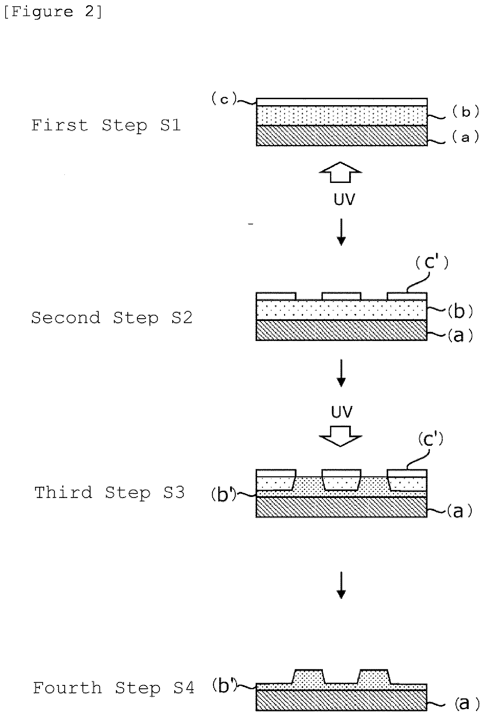

Figure 2 shows a schematic diagram illustrating a method for producing a flexographic printing plate using an original flexographic printing plate according to the present embodiment. Hereinafter, each step is described in detail.

(First Step: S1)

In the first step, the method of performing ultraviolet ray irradiation to the photosensitive resin composition layer (b) from a side of the support (a) is not particularly limited, and can be carried out using a known irradiation unit. The wavelength of ultraviolet ray in the irradiation is preferably 150 to 500 nm, more preferably 300 to 400 nm.

The light source of the ultraviolet ray is not limited to the following, but, for example, a low-pressure mercury lamp, a high-pressure mercury lamp, an ultrahigh-pressure mercury lamp, a metal halide lamp, a xenon lamp, a zirconium lamp, a carbon arc lamp, or a fluorescent lamp for ultraviolet ray can be used.

This first step may be performed before or after the second step described later.

(Second Step: S2)

In the second step, the method for drawing and processing a pattern on the infrared ray ablation layer (c) by infrared ray irradiation is not particularly limited, and can be carried out using a known irradiation unit. The irradiation of infrared ray to the infrared ray ablation layer (c) can be carried out from the side of the infrared ray ablation layer (c).

When the original flexographic printing plate according to the present embodiment has a cover film, the cover film is first peeled off before the infrared ray irradiation. The infrared ray ablation layer (c) is then pattern-irradiated with an infrared ray to decompose the resin of the irradiated part of the infrared ray, and the pattern is drawn and processed. This makes it possible to form a mask (c') of the infrared ray ablation layer (c) on the photosensitive resin composition layer (b).

In the second step, suitable examples of the infrared laser include ND/YAG laser (for example, 1064 nm) or diode laser (for example, 830 nm). Laser systems suitable for CTP plate making techniques are sold on the market, and, for example, a diode laser system CDI Spark (Esko-Graphics BV.) can be used. This laser system includes: a rotary cylindrical drum that holds the original flexographic printing plate according to the present embodiment; IR laser irradiation apparatus; and a layout computer, and image information is directly sent from the layout computer to the laser apparatus.

(Third Step: S3)

In the third step, the photosensitive resin composition layer (b) is irradiated with an ultraviolet ray for pattern exposure using the infrared ray ablation layer (c) on which the pattern is drawn and processed as a mask to form a printing pattern (b'). At this time, the light passing through the mask promotes a curing reaction in the photosensitive resin composition layer (b), and a pattern formed in the infrared ray ablation layer (c) is transferred to the photosensitive resin composition layer (b) in which the convex and concave are inverted. Ultraviolet ray irradiation may be performed on the whole surface of the original flexographic printing plate according to the present embodiment.

The third step can be carried out in a state where the original flexographic printing plate according to the present embodiment is attached to a laser cylinder, but is generally performed by taking the original flexographic printing plate according to the present embodiment out of a laser apparatus, and irradiating using a conventional irradiation unit. The same irradiation unit as the one illustrated in the ultraviolet ray irradiation in the first step can be used as the irradiation unit.

(Fourth Step: S4)

The fourth step is a step of removing the infrared ray ablation layer (b) and an unexposed portion of the photosensitive resin composition layer (c).

In the fourth step (the developing step, the removing method is not particularly limited, and a conventionally known method can be applied.

Specifically, as described above, the photosensitive resin composition layer (b) of the original flexographic printing plate of the present embodiment is exposed to form a printing pattern (b'), and then the unexposed portions are washed with a solvent for solvent development or a washing solution for water development, or the unexposed portions are heated to 40°C to 200°C and contacted with a predetermined absorbent layer that can absorb the heated unexposed portions, and the absorbent layer is removed to get rid of the unexposed portions.

If necessary, a post-exposure treatment is then performed, thereby producing a flexographic printing plate.

When an intermediate layer (d) is located between the infrared ray ablation layer (c) and the photosensitive resin composition layer (b), the intermediate layer (d) may be removed simultaneously in the developing step.

Examples of the solvent for development used for performing solvent development on the unexposed portions include, but are not limited to, esters such as heptyl acetate and 3-methoxybutyl acetate; hydrocarbons such as petroleum fractions, toluene, and decaline; and mixtures obtained by mixing an alcohol such as propanol, butanol, or pentanol with a chlorine-based organic solvent such as tetrachloroethylene. The washing of the unexposed portion is performed by injection from the nozzle or by brushing with a brush.

As the washing solution for water development, water, an alkaline aqueous solution, a neutral detergent, and a surfactant can be suitably used.

Examples of the surfactant include an anionic surfactant, an amphoteric surfactant, and a nonionic surfactant. These may be used singly or as mixtures of two or more thereof.

Examples of the anionic surfactant include, but are not limited to, a sulfuric acid ester salt, a higher alcohol sulfuric acid ester, a higher alkyl ether sulfuric acid ester salt, a sulfated olefin, an alkylbenzenesulfonate, an $\alpha$-olefinsulfonate, a phosphoric acid ester salt, and dithiophosphoric acid ester salt.

Examples of the amphoteric surfactant include, but are not particularly limited to, an amino acid type amphoteric surfactant and a betaine type amphoteric surfactant.

Examples of the nonionic surfactant include, but are not limited to, polyethylene glycol type surfactants such as an ethylene oxide adduct of a higher alcohol, an ethylene oxide adduct of an alkylphenol, an ethylene oxide adduct of an aliphatic acid, an ethylene oxide adduct of a polyhydric alcohol aliphatic acid ester, an ethylene oxide adduct of a higher alkylamine, an ethylene oxide adduct of an aliphatic acid amide, and an ethylene oxide adduct of polypropylene glycol, and polyhydric alcohol type surfactants such as an aliphatic acid ester of glycerol, an aliphatic acid ester of pentaerythritol, an aliphatic acid ester of sorbitol and of sorbitan, an alkyl ether of a polyhydric alcohol, and an aliphatic acid amide of an alkanolamine.

For the alkaline aqueous solution, a pH modifier may be contained. The pH modifier may be any of organic materials and inorganic materials, and preferably enables pH to be adjusted to 9 or higher. Examples of the pH modifier include, but are not limited to, sodium hydroxide, sodium carbonate, potassium carbonate, sodium silicate, sodium metasilicate, and sodium succinate.

Examples of the absorption layer of heat development include, but are not particularly limited to, a nonwoven fabric material, a paper material, a fiber fabric, an open-celled foam, and a porous material. Among these, a non-woven fabric material consisting of nylon, polyester, polypropylene, or polyethylene, and a combination of these non-woven fabric materials are preferred, and a continuous web of non-woven fabric of nylon or polyester is more preferred.

[Flexographic Printing Plate]

The flexographic printing plate of the present embodiment comprises a cured product of a photosensitive resin composition layer made as described above.

The flexographic printing plate of the present embodiment comprises a resin having a Shore A hardness of 61 to 77 and satisfying Formulas (4) and (5) below when the storage modulus is G' (MPa) and the loss modulus is G" (MPa) in a dynamic viscoelastic measurement at -30°C and 2.5 Hz.

$$1.17 \leq G' + G'' \leq 1.80 \quad (4)$$

$$0.17 \leq G'' \leq 0.30 \quad (5)$$

The flexographic printing plate of the present embodiment has the above-mentioned physical properties as a whole, which enables excellent wear resistance during high-speed printing, reduces end blurs, and suppresses the occurrence of a blur during printing.

From the viewpoint of compatibility of the improvement of end blurs and wear resistance, the G'+ G" is preferably 1.40 or more and 1.75 or less, and more preferably 1.50 or more and 1.70 or less.

In the original flexographic printing plate of the present embodiment, from the viewpoint of achieving excellent wear resistance, reducing blurs, and suppressing the occurrence of a blur during high-speed printing, G" is set to 0.17 or more and 0.30 or less, preferably 0.17 or more and 0.29 or less, and more preferably 0.17 or more and 0.25 or less.

The flexographic printing plate of the present embodiment comprises a cured product of a photosensitive resin composition having a Shore A hardness of 61 or more and 77 or less, as described above.

The hardness is a hardness of the entire flexographic printing plate.

When the Shore A hardness is 61 or more, sufficient printing durability is obtained. When the Shore A hardness is 77 or less, sufficient bendability is obtained in the flexographic printing plate and the workability becomes good, for example, when the flexographic printing plate is wrapped around a plate cylinder.

From the viewpoint of compatibility of printing durability and bendability of the flexographic printing plate, the Shore A hardness is 61 or more and 77 or less, preferably 62 or more and 73 or less, and more preferably 63 or more and 70 or less.

In the cured product of the photosensitive resin composition constituting the flexographic printing plate of the present embodiment, the ratio: $\tan\delta = G''/G'$ of the loss modulus G" (MPa) to the storage modulus G' (MPa) in the dynamic viscoelastic measurement at -30°C and 2.5 Hz as described above is preferably 0.17 or more and 0.20 or less, more preferably 0.17 or more and 0.19 or less, and even more preferably 0.17 or more and 0.18 or less.

The physical property value is a physical property value of the entire resin constituting the flexographic printing plate.

In the above range, the effects of improving end blurs and suppressing the occurrence of an end blur are observed even when printing at a higher speed.

[Flexographic Printing Method]

The flexographic printing method according to the present embodiment, using the original flexographic printing plate described above, includes a first step of performing ultraviolet ray irradiation from a side of the support (a); a second step of drawing and processing a pattern on the infrared ray ablation layer (c) by infrared ray irradiation; a third step of irradiating the photosensitive resin composition layer (b) with an ultraviolet ray for pattern exposure using, as a mask, the infrared ray ablation layer (c) on which the pattern is drawn and processed; a fourth step of removing the infrared ray ablation layer (c) and an unexposed portion of the photosensitive resin composition layer (b) to produce a flexographic printing plate; and a fifth step of performing printing using the flexographic printing plate.

The first to fourth steps in the flexographic printing method are as described above.

(Fifth Step)

The fifth step is a step of performing printing using the flexographic printing plate obtained by the first step to the fourth step. The printing method using the flexographic printing plate is not particularly limited as long as the printing method is a method in which ink is attached to a convex portion of the flexographic printing plate and the ink is transferred to a substrate.

Examples

Hereinafter, the present embodiment will be described more specifically with reference to specific Examples and Comparative Examples, but the present invention is not limited to the following Examples and Comparative Examples by any means.

Regarding Examples and Comparative Examples described later, the methods for measuring physical properties are shown below.

[Content of Naphthenic Hydrocarbon Compound Based on Total Amount of Liquid Diene and Naphthenic Hydrocarbon Compound Contained in Photosensitive Resin Composition]

The content of naphthenic hydrocarbon compound based on the total amount of liquid diene and naphthenic hydrocarbon compound contained in the photosensitive resin composition (hereinafter, this content is referred to as A) was calculated using Formula (7) below.

The number average molecular weight (Mn) of liquid diene and naphthenic hydrocarbon compound was measured with the following device under the following conditions.

A (mol%) = (mass of naphthenic hydrocarbon compound added/Mn of naphthenic hydrocarbon compound)/ {(mass of naphthenic hydrocarbon compound added/Mn of naphthenic hydrocarbon compound) + (mass of liquid diene added/Mn of liquid diene)} (7)  (7)

  Device: HLC-8220 GPC manufactured by Tosoh Corporation
  Column: The following four columns were connected in series to separate compounds.
  TSKgel GMH XL manufactured by Tosoh Corporation + TSKgel GMH XL manufactured by Tosoh Corporation + TSKgel GMH XLL manufactured by Tosoh Corporation + TSKgel GMH XLL manufactured by Tosoh Corporation
  Column temperature: 40°C
  Solvent: Tetrahydrofuran
  Detector: RI
  Calibration curve: standard polystyrene

[Measurement of Naphthene Ratio of Naphthenic Hydrocarbon Compound Contained in Photosensitive Resin Composition]

For the naphthenic hydrocarbon compound, V.G.C (viscosity specific gravity constant) and $r_i$ (refractive index) were measured and calculated in accordance with ASTM D2140-08 (2017) according to the Kurtz method, and the percentage of naphthene carbon number to total carbon number derived from those values was taken as the naphthene ratio.

[Measurement of Shore A Hardness]

The photosensitive resin composition was sandwiched with release films (manufactured by Mitsubishi Chemical Corporation, DIAFOIL MRV100), and subjected to a pressure of 200 kg/cm$^2$ at the conditions of 120°C for 4 minutes using a 1.5 mm spacer with a press to obtain a photosensitive resin composition sheet having a photosensitive resin composition layer (b) of a thickness of 1.5 mm.

Subsequently, the photosensitive resin composition sheet was irradiated from both sides of the sheet each with 3,000 mJ/cm$^2$ of ultraviolet ray for full exposure using an ultraviolet fluorescent lamp having a central wavelength at 370 nm on an exposure machine "AFP-1216" (manufactured by Asahi Kasei Corporation, trade name) to prepare a sample for Shore A hardness evaluation.

The release film of the obtained sample was peeled off and left in a constant temperature and humidity chamber at a temperature of 23°C and relative humidity of 55% for one day, and then the measurement was performed using a JIS constant pressure loader GS-710 (manufactured by TECLOCK Co., Ltd., Durometer GS-719G ASTM: D2240A, JIS: K6253A, ISO: 7619A).

The value after 15 seconds of loading (1 kg mass) on the solid face was taken as the Shore A hardness.

In the Shore A hardness evaluation of the photosensitive resin composition layer (b) from the original flexographic printing plate, the infrared ray ablation layer (c) constituting the original flexographic printing plate was first wiped off with a non-woven fabric using a solvent such as acetone, and then the obtained laminate of the support (a) and the photosensitive resin composition layer (b) was subjected to a pressure of 50 kg/cm$^2$ for 4 minutes under the condition of 120°C with a press, and the photosensitive resin composition layer (b) extending beyond the support (a) was recovered. Next, the recovered photosensitive resin composition was sandwiched with release films, and subjected to a pressure of 200 kg/cm$^2$ at the condition of 120°C for 4 minutes using a 1.5 mm spacer with a press to obtain a photosensitive resin composition sheet having a photosensitive resin composition layer (b) of a thickness of 1.5 mm. Then, the photosensitive resin composition sheet was irradiated from both sides of the sheet each with 3,000 mJ/cm$^2$ of ultraviolet ray for full exposure using an exposure machine "AFP-1216" to prepare a sample for Shore A hardness evaluation, and the measurement was performed in the same manner as the measurement method described above.

In the measurement of the Shore A hardness of the flexographic printing plate, the flexographic printing plate was left in a constant temperature and humidity chamber at a temperature of 23°C and relative humidity of 55% for one day, and then a Shore A hardness measurement was performed on solid image portions the flexographic printing plate using a JIS constant pressure loader GS-710 described above.

In each Example and Comparative Example, the Shore A hardness measurement was performed using the sample for Shore A hardness evaluation made from the photosensitive resin composition and a flexographic printing plate.

[Measurement of Dynamic Viscoelasticity]

The photosensitive resin composition was sandwiched with release films, and subjected to a pressure of 200 kg/cm$^2$ at the conditions of 120°C for 4 minutes using a 1.5 mm spacer with a press to obtain a photosensitive resin composition sheet having a photosensitive resin composition layer (b) of a thickness of 1.5 mm. Subsequently, the photosensitive resin composition sheet was irradiated from both sides of the sheet each with 3,000 mJ/cm$^2$ of ultraviolet ray for full exposure using an exposure machine "AFP-1216" to prepare a sample for dynamic viscoelasticity evaluation.

The release films of the resulting sample were peeled off and the cured product of a thickness of 1.5 mm was formed into a circle shape of a diameter of 8 mm using a drilling punch. The obtained circular sample was set onto an 8 mm-diameter parallel plate of Discovery Hybrid Rheometer 2 (manufactured by TA Instruments, trademark), and dynamic viscoelastic measurements, i.e., measurements of storage modulus (G'), loss modulus (G''), and tan$\delta$ (G''/G') were performed at the measurement temperature of -30°C and in the range of measurement frequency of 0.1 Hz to 100.0 Hz with setting the force in the axial direction (normal stress) to 5 N, the sensitivity to 0.1 N, and strain in the rotational direction to 0.1.

In the dynamic viscoelasticity evaluation of the photosensitive resin composition layer (b) from the original flexographic printing plate, the infrared ray ablation layer (c) constituting the original flexographic printing plate was first wiped off with a non-woven fabric using a solvent such as acetone, and then the obtained laminate of the support (a) and the photosensitive resin composition layer (b) was subjected to a pressure of 50 kg/cm$^2$ for 4 minutes under the conditions of 120°C with a press, and the photosensitive resin composition layer (b) extending beyond the support (a) was recovered. Next, the recovered photosensitive resin composition was sandwiched with release films, and subjected to a pressure of 200 kg/cm$^2$ at the conditions of 120°C for 4 minutes using a 1.5 mm spacer with a press to obtain a photosensitive resin composition sheet having a photosensitive resin composition layer (b) of a thickness of 1.5 mm. Then, the photosensitive resin composition sheet was irradiated from both sides of the sheet each with 3,000 mJ/cm$^2$ of ultraviolet ray for full exposure using an exposure machine "AFP-1216" to prepare a sample for dynamic viscoelasticity measurement, and the viscoelasticity measurement was performed in the same manner as the measurement method described above.

In the dynamic viscoelasticity evaluation of the photosensitive resin composition layer (b) constituting the flexographic printing plate, the portion from the design surface to the depth of 1.5 mm in the solid image portions the flexographic printing plate of a plate thickness of 1.7 mm was cut out using a cutter or the like, and the obtained photocured product of a thickness of 1.5 mm was formed into a circle shape with a diameter of 8 mm using a drilling punch, and then dynamic viscoelasticity measurement was performed in the same manner as the measurement method described above.

In each Example and Comparative Example, the viscoelasticity measurement was performed on the sample for dynamic viscoelasticity evaluation made from the photosensitive resin composition and a photosensitive resin composition layer (b) constituting the flexographic printing plate. It was confirmed that similar measurement results were obtained in the case using the samples made from the photosensitive resin composition and the case using the samples made using the original flexographic printing plate.

<Production Examples>

(Preparation of Laminate for Forming Infrared Ray Ablation Layer)

100 parts by mass of carbon black (CB) as an infrared ray absorber, 20 parts by mass of Solsperse 39000 (manufactured by Japan Lubrizol corporation, trade name, base value 30 mg KOH/g) as a dispersant, 80 parts by mass of TUFTEC H1051 (manufactured by Asahi Kasei Corporation, trade name), which is a hydrogen additive of a styrene-butadiene-styrene copolymer elastomer, as a binder polymer, and 600 parts by mass of toluene were mixed to obtain an infrared ray ablation layer coating solution.

This infrared ray ablation layer coating solution was applied to coat a PET film having a thickness of 100 $\mu$m as a cover film so that the film thickness after drying was 3 $\mu$m, and a drying treatment was performed at 90°C for 2 minutes to obtain a laminate for forming an infrared ray ablation layer, which was a laminate of the infrared ray ablation layer and the cover film.

(Production of Photosensitive Resin Composition)

<Production of Photosensitive Resin Composition 1>

70.0 parts by mass of styrene-butadiene-styrene copolymer [D-KX405: manufactured by Kraton Corporation], 13.0 parts by mass of liquid polybutadiene [LBR-352: manufactured by Kuraray Co., Ltd.], 10.0 parts by mass of plasticizer [Regalite R1010: manufactured by EASTMAN CHEMICAL COMPANY], 7.0 parts by mass of 1,9-nonanediol diacrylate, 3.5 parts by mass of photopolymerization initiator [2,2-dimethoxy-2-phenylacetophenone: manufactured by BASF SE], and 0.6 parts by mass of antioxidant [2,6-di-t-butyl-p-cresol: manufactured by SUMITOMO CHEMICAL Co., Ltd.] were kneaded with a pressure kneader to prepare a photosensitive resin composition 1 (referred to as resin 1 in Table 1).

<Production Examples of Photosensitive Resin Compositions 2 to 13>

The photosensitive resin compositions 2 to 13 (referred to as resins 2 to 13 in Table 1) were obtained in the same manner as the photosensitive resin composition 1 except that the composition was changed as shown in Table 1 below.

Each material in Table 1 is shown below.

D-KX405: styrene-butadiene-styrene copolymer manufactured by KRATON CORPORATION
D-1102: styrene-butadiene-styrene copolymer manufactured by KRATON CORPORATION
TUFPRENE 315P: styrene-butadiene-styrene copolymer, manufactured by Asahi Kasei Corporation
LBR-352: liquid polybutadiene, manufactured by Kuraray Co., Ltd.
Regalite R1010: naphthenic hydrocarbon compound (naphthene/paraffin ratio = 70/30) manufactured by EASTMAN CHEMICAL COMPANY
SMOIL P-350: paraffinic hydrocarbon compound (naphthene/paraffin ratio = 30/70) manufactured by Matsumura Oil Co., Ltd.

[Table 1]

| | Mixing amount unit: parts by mass | Resin 1 | Resin 2 | Resin 3 | Resin 4 | Resin 5 | Resin 6 | Resin 7 | Resin 8 | Resin 9 | Resin 10 | Resin 11 | Resin 12 | Resin 13 |
|---|---|---|---|---|---|---|---|---|---|---|---|---|---|---|
| Thermoplastic elastomer (b-1) | D-KX405 | 70.0 | 57.5 | | 70.0 | 70.0 | 70.0 | | | 70.0 | 70.0 | | 57.5 | 70.0 |
| | D-1102 | | | 62.5 | | | | | 70.0 | | | 57.0 | | |
| | TUFPRENE 315P | | | | | | | 67.5 | | | | | | |
| Liquid diene | LBR-352 | 13.0 | 11.5 | 14.5 | 11.5 | 16.5 | 18.5 | 15.4 | 10.0 | 11.5 | 21.5 | 15.0 | 17.5 | 6.5 |
| Plasticizer (b-4) | Regalite R1010 (naphthene ratio = 70%) | 10.0 | 20.0 | 12.0 | 9.0 | 5.0 | 3.0 | 10.0 | 9.0 | 8.0 | | 20.0 | 15.0 | |
| | SMOIL P-350 (naphthene ratio = 30%) | | | | | | | | | | | | | 15.0 |
| Ethylenically unsaturated compound (b-2) | 1,9-nonanediol diacrylate | 7.0 | 9.0 | 9.0 | 10.0 | 9.0 | 9.0 | 4.5 | 9.0 | 11.0 | 9.0 | 7.0 | 7.5 | 9.0 |
| | 1,6-hexanediol dimethacrylate | | 2.0 | 2.0 | 2.0 | 2.0 | 2.0 | 2.0 | 2.0 | 2.0 | 2.0 | 2.0 | 2.0 | 2.0 |

EP 4 527 634 A1

[Example 1]

[Preparation of Samples for Cold Flow Resistance Evaluation]

The photosensitive resin composition 1 was sandwiched with release films (manufactured by Mitsubishi Chemical Corporation, DIAFOIL MRV100), and subjected to a pressure of 200 kg/cm$^2$ at the condition of 130°C for 4 minutes using a 3 mm spacer with a heating press, and then cooled to obtain a photosensitive resin structure of 25 cm in length × 25 cm in width × 3 mm in thickness.

<Preparation of Flexographic Printing Plate>

The photosensitive resin composition 1 was added to an extruder. Then, a support (polyethylene terephthalate film) was laminated to one side of the photosensitive resin composition layer extruded from a T-die, and a release film (manufactured by Mitsubishi Chemical Corporation, DIAFOIL MRV100) was laminated to the side opposite to the support-laminated side of the photosensitive resin composition layer was laminated, thereby obtaining a laminate (thickness: 1.8 mm) of the support and the photosensitive resin composition layer.
The release film was then peeled, and the laminate for forming an infrared ray ablation layer obtained in the [Production Examples] described above was laminated so that the infrared ray ablation layer was in contact with the photosensitive resin composition layer to obtain an original flexographic printing plate of a plate thickness of 1.8 mm.
Then, the original flexographic printing plate was exposed from the support (polyethylene terephthalate film) side using an exposure machine "AFP-1216" so that the pattern height (RD) after curing was about 0.7 mm.
Next, the cover film of the infrared ray ablation layer was peeled off, and drawing was performed onto the infrared ray ablation layer using a laser drawing machine (CDI) manufactured by ESKO, and then an image (relief) exposure of 6,000 mJ/cm$^2$ was performed with the exposure machine from the infrared ray ablation layer side.
Then, development was performed using Solvit (manufactured by MacDermid Performance Solutions, trademark, a mixed organic solvent of 60% by mass of hydrocarbons and 40% by mass of aliphatic alcohol, boiling point 155-205°C) as a developing solution with a developing machine "AFP-1321P" (manufactured by Asahi Kasei Corporation, trademark) at a liquid temperature of 30°C with a speed of 135 mm/min, and then drying was performed at 60°C for 2 hours.
Subsequently, as post-processing exposure, an exposure of 2,000 mJ/cm$^2$ was performed on the entire plate surface using a sterilization lamp with a center wavelength of 254 nm, followed by an exposure of 1,000 mJ/cm$^2$ using an ultraviolet ray fluorescent lamp to obtain a flexographic printing plate having a plate thickness of 1.7 mm.

[Examples 2 to 6, Comparative Examples 1 to 7]

A sample for cold flow resistance evaluation and a flexographic printing plate were obtained in the same manner as in Example 1 except that the photosensitive resin composition used was changed.
The photosensitive resin compositions used in each of Examples 2 to 6 and Comparative Examples 1 to 7 are shown in Table 2.

[Evaluation Method]

<Plate Printing Durability during High-Speed Printing>

In the printing test at a printing speed of 600 m/min in <the high-speed printing test> described later, the area ratio of 133 lpi, 10% dot portions of the printing plate was measured before and after printing by an image processing analysis device Luzex AP (manufactured by NIRECO CORPORATION), and the change rate of the area ratio before and after printing was calculated.
The evaluation was performed according to the following criteria. The evaluation results are shown in Tables 2 to 3 below.

(Evaluation Criteria)

A: The change in the area ratio is 0% or more and less than 5%.
B: The change in the area ratio is 5% or more and less than 6%.
C: The change in the area ratio is 6% or more and less than 7%.
E: The change in the area ratio is 7% or more.

<Bendability of Plate>

Using the flexographic printing plates obtained in [Examples] and [Comparative Examples], both ends of the flexographic printing plate were bent 100 times in the same direction so that the support-laminated side of the flexographic printing plate was inward with a curvature of 150 mmφ.

The state of the plate after bending was visually observed from the support-laminated side and evaluated according to the criteria shown below.

The evaluation results are shown in Tables 2 to 3 below. (Evaluation Criteria)

A: There is no crack on the plate at all.
C: There are a few cracks on the plate.
E: There are many cracks on the plate.

<High-Speed Printing Test: Extent of Blurs and Difficulty of Occurrence of Blur>

A printing test was performed using the flexographic printing plates obtained in [Examples] and [Comparative Examples] with a flexographic printer.

DuploFLEX 5.2 Plus (manufactured by Lohmann GmbH & Co. KG, trademark) was applied as a cushion tape on the support-laminated side of the flexographic printing plate, and XS-716 (manufactured by DIC Graphics Corporation, trademark) was used as an aqueous ink, and an 800 lpi anilox roll (cell capacity 3.8 $cm^3/m^2$) of carton paper was used as the body to be printed. For each of the three types of printing speed conditions, that is, printing speed 350 m/min, printing speed 450 m/min, and printing speed 600 m/min, 10,000 m of printing was performed, and then the solid portion of the printed material was visually observed.

The extent of blurs was evaluated as A when the blurs were minimum and the good print quality was maintained, and as the extent of blurs deteriorated, it was ranked as B, C, and E.

The difficulty of occurrence of a blur was evaluated according to the following criteria.

The evaluation results are shown in Tables 2 to 3 below.

(Evaluation Criteria of Difficulty of Occurrence of Blur)

A: Even at the printing speed of 600 m/min, blurs of the printed material cannot be visually observed.
B: For the first time at the printing speed of 600 m/min, blurs of the printed material can be visually observed.
C: From the printing speed of 450 m/min, blurs of the printed material can be visually observed.
E: From the printing speed of 350 m/min, blurs of the printed material can be visually observed.

<Evaluation of Cold Flow Resistance>

The photosensitive resin structure, a sample for cold flow resistance evaluation having a thickness of 3 mm obtained in [Examples] and [Comparative Examples], was cut into 5 cm × 5 cm, and the thickness change was measured after standing still at 40°C for 7 days under a load of 28 $g/cm^2$ on the whole surface.

The evaluation was performed according to the following criteria.

The evaluation results are shown in Tables 2 to 3 below.

(Evaluation Criteria)

A: The thickness reduction rate is less than 2.0%.
B: The thickness reduction rate is 2.0% or more and less than 2.5%.
C: The thickness reduction rate is 2.5% or more and less than 3.0%.

[Table 2]

| | | | Example 1 | Example 2 | Example 3 | Example 4 | Example 5 | Example 6 |
|---|---|---|---|---|---|---|---|---|
| Photosensitive resin composition layer (b) | | | Resin 1 | Resin 2 | Resin 3 | Resin 4 | Resin 5 | Resin 6 |
| Plasticizer contained in photosensitive resin composition layer (b) | | | Regalite R1010 (naphthene ratio = 70%) | Regalite R1010 (naphthene ratio = 70%) | Regalite R1010 (naphthene ratio = 70%) | Regalite R1010 (naphthene ratio = 70%) | Regalite R1010 (naphthene ratio = 70%) | Regalite R1010 (naphthene ratio = 70%) |
| Measurement item | Content of plasticizer based on total amount of liquid diene and plasticizer | | 96 mol% | 98 mol% | 97 mol% | 96 mol% | 91 mol% | 85 mol% |
| | Physical property measurement using photosensitive resin composition | Shore A hardness | 67 | 60 | 75 | 65 | 64 | 64 |
| | | G' + G" (measurement temperature -30°C, measurement frequency 2.5 Hz) | 1.60 | 1.04 | 1.49 | 1.79 | 1.70 | 1.69 |
| | | G" (measurement temperature -30°C, measurement frequency 2.5 Hz) | 0.24 | 0.16 | 0.24 | 0.30 | 0.29 | 0.30 |
| | | $\tan\delta$ (measurement temperature -30°C, measurement frequency 2.5 Hz) | 0.18 | 0.18 | 0.19 | 0.20 | 0.20 | 0.22 |
| | Physical property measurement using flexographic printing plate | Shore A hardness | 68 | 61 | 77 | 67 | 67 | 67 |
| | | G' + G" (measurement temperature -30°C, measurement frequency 2.5 Hz) | 1.65 | 1.17 | 1.52 | 1.80 | 1.73 | 1.71 |
| | | G" (measurement temperature -30°C, measurement frequency 2.5 Hz) | 0.25 | 0.18 | 0.24 | 0.30 | 0.29 | 0.31 |
| | | $\tan\delta$ (measurement temperature -30°C, measurement frequency 2.5 Hz) | 0.18 | 0.18 | 0.19 | 0.20 | 0.20 | 0.22 |

(continued)

| Evaluation item | Example 1 | Example 2 | Example 3 | Example 4 | Example 5 | Example 6 |
|---|---|---|---|---|---|---|
| Plate printing durability during high-speed printing | A | B | A | A | A | A |
| Plate bendability | A | A | C | A | A | A |
| Extent of blurs of printed material during high-speed printing | A | A | A | C | B | B |
| Difficulty of occurrence of blur during high-speed printing | A | A | A | B | B | C |
| Cold flow resistance | A | C | A | A | A | A |

[Table 3]

| | Comparative Example 1 | Comparative Example 2 | Comparative Example 3 | Comparative Example 4 | Comparative Example 5 | Comparative Example 6 | Comparative Example 7 |
|---|---|---|---|---|---|---|---|
| Photosensitive resin composition layer (b) | Resin 7 | Resin 8 | Resin 9 | Resin 10 | Resin 11 | Resin 12 | Resin 13 |
| Plasticizer contained in photosensitive resin composition layer (b) | Regalite R1010 (naphthene ratio = 70%) | Regalite R1010 (naphthene ratio = 70%) | Regalite R1010 (naphthene ratio = 70%) | Not contained | Regalite R1010 (naphthene ratio = 70%) | Regalite R1010 (naphthene ratio = 70%) | SMOIL P-350 (naphthene ratio = 30%) |

| Measurement item | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| | Content of plasticizer based on total amount of liquid diene and plasticizer | | 94 mol% | 97 mol% | 97 mol% | Not contained | 99 mol% | 98 mol% | 98 mol% |
| | Physical property measurement using photosensitive resin composition | Shore A hardness | 54 | 77 | 67 | 66 | 56 | 60 | 63 |
| | | G' + G" (measurement temperature - 30°C, measurement frequency 2.5 Hz) | 1.70 | 1.61 | 1.86 | 1.84 | 1.03 | 0.95 | 1.39 |
| | | G" (measurement temperature -30°C, measurement frequency 2.5 Hz) | 0.39 | 0.26 | 0.31 | 0.35 | 0.17 | 0.17 | 0.15 |
| | | tan$\delta$ (measurement temperature - 30°C, measurement frequency 2.5 Hz) | 0.31 | 0.19 | 0.20 | 0.24 | 0.19 | 0.19 | 0.12 |
| | Physical property measurement using flexographic printing plate | Shore A hardness | 56 | 79 | 69 | 68 | 58 | 62 | 64 |
| | | G' + G" (measurement temperature - 30°C, measurement frequency 2.5 Hz) | 1.76 | 1.63 | 1.89 | 1.85 | 1.12 | 1.06 | 1.45 |
| | | G" (measurement temperature -30°C, measurement frequency 2.5 Hz) | 0.42 | 0.27 | 0.33 | 0.36 | 0.19 | 0.18 | 0.18 |
| | | tan$\delta$ (measurement temperature - 30°C, measurement frequency 2.5 Hz) | 0.31 | 0.20 | 0.21 | 0.24 | 0.20 | 0.20 | 0.14 |

EP 4 527 634 A1

| | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| Evaluation item | Plate printing durability during high-speed printing | E | A | A | A | C | C | C |
| | Plate bendability | A | E | A | A | A | A | A |
| | Extent of blurs of printed material during high-speed printing | B | A | E | E | A | A | A |
| | Difficulty of occurrence of blur during high-speed printing | E | A | B | E | A | A | A |
| | Cold flow resistance | A | A | A | A | C | C | C |

This application is based on the Japanese Patent Application (Patent Application No. 2022-081622) filed with the Japan Patent Office on May 18, 2022, the contents of which are hereby incorporated by reference.

Industrial Applicability

The original flexographic printing plate according to the present invention has industrial applicability in the flexographic printing plate production field.

Reference Signs List

(a) Support
(b) Photosensitive resin composition layer
(b') Print pattern
(c) Infrared ray ablation layer
(c') Mask of infrared ray ablation layer

**Claims**

1. An original flexographic printing plate comprising at least: a support (a); and a photosensitive resin composition layer (b) laminated thereon,

   wherein the photosensitive resin composition layer (b) comprises a naphthenic hydrocarbon compound having a naphthene ratio of 60% or more and 80% or less and satisfies the following <condition 1>:
   <condition 1>
   a cured product obtained by molding a photosensitive resin composition constituting the photosensitive resin composition layer (b) to a thickness of 1.5 mm and irradiating from a top side and a bottom side each with 3,000 mJ of ultraviolet ray has a Shore A hardness of 60 or more and 75 or less; and
   a storage modulus G' (MPa) and a loss modulus G" (MPa) of the cured product in a dynamic viscoelastic measurement at -30°C and 2.5 Hz satisfy Formulas (1) and (2) below:

$$1.04 \leq G' + G'' \leq 1.79 \quad (1)$$

$$0.15 \leq G'' \leq 0.30 \quad (2).$$

2. The original flexographic printing plate according to claim 1, wherein
   a ratio: $\tan\delta = G''/G'$ of the loss modulus G" (MPa) to the storage modulus G' (MPa) of the cured product in a dynamic viscoelastic measurement at -30°C and 2.5 Hz satisfies Formula (3) below:

$$0.17 \leq \tan\delta \leq 0.20 \quad (3).$$

3. The original flexographic printing plate according to claim 1 or 2, wherein the naphthene ratio of the naphthenic hydrocarbon compound is 65% or more and 73% or less.

4. The original flexographic printing plate according to claim 1 or 2, wherein
   a content of the naphthenic hydrocarbon compound in the photosensitive resin composition layer (b) is 3% by mass or more and 20% by mass or less.

5. The original flexographic printing plate according to claim 1 or 2, wherein

   the photosensitive resin composition layer (b) further comprises a liquid conjugated diene, and
   a content of the naphthenic hydrocarbon compound based on a total amount of the liquid conjugated diene and the naphthenic hydrocarbon compound is 91 mol% or more and 99 mol% or less.

6.  A method for producing a flexographic printing plate, using the original flexographic printing plate according to claim 1 or 2, the method comprising:

    a first step of irradiating the original flexographic printing plate with an ultraviolet ray from the support (a) side;
    a second step of placing a negative film on the photosensitive resin composition layer (b) or laser-ablating an infrared ray ablation layer (c) provided on the photosensitive resin composition layer (b) to form a negative pattern;
    a third step of irradiating the photosensitive resin composition layer (b) with an ultraviolet ray for pattern exposure through the negative film or using, as a mask, the infrared ray ablation layer (c) on which the pattern is drawn and processed; and
    a fourth step of removing an unexposed portion of the photosensitive resin composition layer (b).

7.  A flexographic printing plate comprising a cured product of a photosensitive resin composition, wherein the cured product has a Shore A hardness of 61 or more and 77 or less; and
    a storage modulus G' (MPa) and a loss modulus G" (MPa) of the cured product in a dynamic viscoelastic measurement at -30°C and 2.5 Hz satisfy Formulas (4) and (5) below:

$$1.17 \leq G' + G'' \leq 1.80 \quad (4)$$

$$0.17 \leq G'' \leq 0.30 \quad (5).$$

8.  The flexographic printing plate according to claim 7, wherein a ratio: $\tan\delta = G''/G'$ of the loss modulus G" (MPa) to the storage modulus G' (MPa) of the cured product of a photosensitive resin composition in a dynamic viscoelastic measurement at -30°C and 2.5 Hz satisfies Formula (6) below:

$$0.17 \leq \tan\delta \leq 0.20 \quad (6).$$

9.  A flexographic printing method using the flexographic printing plate according to claim 7 or 8, the method comprising:

    an ink-attaching step of attaching ink to a convex portion of the flexographic printing plate; and
    a transferring step of transferring the ink to a substrate.

[Figure 1]

<u>1</u>

(c)

(b)

(a)

[Figure 2]

First Step S1

(c), (b), (a)

UV

Second Step S2

(c'), (b), (a)

UV

Third Step S3

(b'), (c'), (a)

Fourth Step S4

(b'), (a)

[Figure 3]

Master curve (reference 20°C)

G'+G" (MPa) vs Frequency (Hz)

— [Example 1] sample

<table>
<tr><td colspan="2">**INTERNATIONAL SEARCH REPORT**</td><td colspan="2">International application No.<br>**PCT/JP2023/017605**</td></tr>
</table>

**A.    CLASSIFICATION OF SUBJECT MATTER**

***B41N 1/12****(2006.01)i; ****B41C 1/05****(2006.01)i; ****B41M 1/04****(2006.01)i; ****G03F 7/00****(2006.01)i; ****G03F 7/095****(2006.01)i*
FI:    B41N1/12; B41C1/05; B41M1/04; G03F7/00 502; G03F7/095

According to International Patent Classification (IPC) or to both national classification and IPC

**B.    FIELDS SEARCHED**

Minimum documentation searched (classification system followed by classification symbols)

B41N1/12; B41C1/05; B41M1/04; G03F7/00; G03F7/095

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2019-171730 A (TORAY INDUSTRIES) 10 October 2019 (2019-10-10)<br>entire text | 1-9 |
| A | JP 2019-109444 A (ASAHI KASEI CORP) 04 July 2019 (2019-07-04)<br>entire text | 1-9 |
| A | JP 2019-109436 A (ASAHI KASEI CORP) 04 July 2019 (2019-07-04)<br>entire text | 1-9 |
| A | JP 2017-114024 A (SUMITOMO RIKO CO LTD) 29 June 2017 (2017-06-29)<br>entire text | 1-9 |
| A | JP 2013-111903 A (FUJIFILM CORP) 10 June 2013 (2013-06-10)<br>entire text | 1-9 |
| A | WO 2007/058163 A1 (ASAHI KASEI CHEMICALS CORPORATION) 24 May 2007<br>(2007-05-24)<br>entire text | 1-9 |

☑ Further documents are listed in the continuation of Box C.          ☑ See patent family annex.

| | |
|---|---|
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| **09 June 2023** | **20 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
|---|
| **PCT/JP2023/017605** |

**C.    DOCUMENTS CONSIDERED TO BE RELEVANT**

| Category* | Citation of document, with indication, where appropriate, of the relevant passages | Relevant to claim No. |
|---|---|---|
| A | JP 5-134425 A (TOKYO OHKA KOGYO CO LTD) 28 May 1993 (1993-05-28) <br> entire text | 1-9 |
| A | US 2020/0009787 A1 (AGFA NV) 09 January 2020 (2020-01-09) <br> entire text, all drawings | 1-9 |

Form PCT/ISA/210 (second sheet) (January 2015)

**INTERNATIONAL SEARCH REPORT**
Information on patent family members

International application No.

**PCT/JP2023/017605**

| Patent document cited in search report | | | Publication date (day/month/year) | Patent family member(s) | | | Publication date (day/month/year) |
|---|---|---|---|---|---|---|---|
| JP | 2019-171730 | A | 10 October 2019 | (Family: none) | | | |
| JP | 2019-109444 | A | 04 July 2019 | (Family: none) | | | |
| JP | 2019-109436 | A | 04 July 2019 | (Family: none) | | | |
| JP | 2017-114024 | A | 29 June 2017 | (Family: none) | | | |
| JP | 2013-111903 | A | 10 June 2013 | US<br>EP | 2013/0133538<br>2599813 | A1<br>A2 | |
| WO | 2007/058163 | A1 | 24 May 2007 | US<br>EP | 2009/0155721<br>1953594 | A1<br>A1 | |
| JP | 5-134425 | A | 28 May 1993 | EP | 542254 | A1 | |
| US | 2020/0009787 | A1 | 09 January 2020 | WO<br>EP | 2018/114655<br>3558646 | A1<br>A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007058163 A
- JP 2019 A
- JP 171730 A
- JP 5013305 A
- WO 2004104701 A
- JP 2022081622 A